# EUROPEAN PATENT SPECIFICATION

(11) **EP 0 341 047 B1**
(45) Date of publication and mention of the grant of the patent: **26.03.1997**
(21) Application number: 89304460.2
(22) Date of filing: 03.05.1989
(51) Int. Cl.: G03C 11/00, B41M 1/24, B44C 1/17, B42B 15/02, G03F 7/00

(54) **Pre-imaged high resolution hot stamp transfer foil, article and method**
Bebilderte Prägefolie für Wärmeübertragung, Artikel und Verfahren
Feuille d'estampage pour transfert à chaud avec image préformée, article et méthode

(30) Priority: 03.05.1988 US 189620
(43) Date of publication of application: 08.11.1989
(73) Proprietor: FLEX PRODUCTS, INC., Santa Rosa California 95407 (US)
(72) Inventor: Phillips, Roger W., Santa Rosa California 95405 (US); Willison, Craig R., Santa Rosa California 95405 (US)
(74) Representative: Bayliss, Geoffrey Cyril

(56) References cited:
- EP-A- 0 170 439
- EP-A- 0 170 832
- EP-A- 0 193 334
- DE-C- 3 430 111
- GB-A- 2 129 739
- GB-A- 2 141 667
- US-A- 4 343 874
- Patent Abstracts of Japan, vol.11, Number 1 (M-550)[2448], January 6, 1987 & JP-A 61-179780

## Description

This invention relates to a pre-imaged high resolution transfer foil, article and method and more particularly to such a pre-imaged high resolution hot stamp transfer foil, article and method which can be utilized with flexible and rigid substrates, as well as transparent and opaque substrates.

Heretofore hot stamp transfer foils have been provided in conjunction with hot stamp machines to stamp images on to various substrates such as paper, plastic film and even rigid substrates. Typically the image is formed by utilizing a metal die into which the desired image has been cut. This die is placed in the hot stamping machine and is used to press the image into hot stamp foil utilizing a combination of heat and pressure. Typically a heat activated adhesive is placed on the back side of the foil which upon the application of heat becomes tacky in regions of the heated image and adheres to the paper or plastic substrate. The resolution and image which is formed in this manner is on the order of 0.1 mm at best. This is due to the fact that heat introduced during the process spreads out radially through the adhesive and the substrate. If the hot stamping foil carrier substrate is thicker than approximately 48 gauge, the image which is created has edges which are ragged, i. e., the edges are fringed because the radially spreading heat spreads further than the thicker substrate. This phenomenon also occurs if the hardcoat (the release layer) and the adhesive are thick. Thus it is desirable that the substrate as, for example, PET (polyethyleneterephthalate) the adhesive and the hardcoat must be at an optimum thickness. If the PET is too thin it will tear in the hot stamping machine and not survive the vacuum metalizing step. If it is too thick, then the above-described fringing results. If the hardcoat is too thin then the hot stamp foil will not release properly or will not give the transfer image enough scratch and mar protection. If the adhesive is too thin, it will not adhere to the substrate upon which the hot stamping image is being placed. If it is desired to vacuum deposit multilayer optical coatings where the coating itself is quite thick, the PET must be at least 36.1 microns (142 gauge) and preferably 50.8 microns (200 gauge) in thickness. This thickness is required so that the heat load arising from the heat of condensation and from the radiant heat from the evaporating source does not deform the web on which the stamping is being made. Depositing materials such as dielectrics, for example, metal oxides, fluorides, sulfides and the like are particularly prone to wrinkling the web. At the thickness of 36.1 microns (142 gauge) for PET, substantial fringing results in the hot stamped transferred image. This fringe when lightly brushed causes the hot stamped image to flake at the edges of the image. At high production speeds this flaking results in the hot stamping machine becoming contaminated with debris. Furthermore, the image is also subject to flaking phenomenon and is unsightly and unacceptable.

EP-A-017032 discloses a pre-imagine high resolution transfer foil, a carrier having a surface, a releasable hard coat disposed on the surface, a vacuum coating deposited on the hard coat and an image formed in the vacuum coating. The image is in the form of a hologram embossed on a thin aluminium layer which is placed on a thick magnetic media layer comprising needle-shaped gammapheric oxide pigment and a polyurethane binder.

EP-A-0170439 discloses a thin film optical variable article having substantial colour shift with varying angle of incidents and viewing. The article comprises an optically thick, substantially transparent element carrying a colourant and having a multilayer interference coating on one surface. The colourant serves to modify in essentially a substrative mode of colour at normal incidents and the colour shift with angle of the multilayer interference coating as seen in reflection or transmission.

GB-A-2129739 discloses a formation of a typical holographic hot stamping foil in which the hot stamp transfer technique includes the steps of bringing the substrate and carrier into engagement with the adhesive, applying heat and pressure and, after that, separating the carrier from the vacuum coating.

GB-A-2141667 discloses a transfer sheet for the colour pattern having a metallic luster comprising at least a transparent or semi-transparent base film, a release film layer on one side of the base film, a transparent colouring agent in the form of a desired pattern on the mould/removing film layer, and an aluminium vapour/coated layer on the transparent colouring layer. An adhesive layer is present on the aluminium vapour/coated layer.

This may be manufactured by etching either using pattern wise adhesive as the resist or by using a photo-resist over the adhesive. A protective layer may be present between the adhesive layer and the aluminum layer.

DE-3430111 C1 discloses a pre-imaged high resolution transfer foil comprising a carrier having a surface, a releasable hardcoat disposed on the surface and a graphic image carrying a vacuum-deposited coating disposed on the hardcoat. An image is formed by etching the partially hardened lacquer layer underlying the vacuum deposited coating. There is no provision of an optical security feature.

EP-A-0193334 discloses an optical card comprising a card substrate and a light reflective layer provided on the substrate. The light reflective layer comprises an optical reflective metallic thin film having a light information pattern formed therein formed by photoetching. Again there is no optical security feature provided.

JP-A 61-179780 discloses a partially vapour-deposited transfer foil comprising a base film having a releasable layer, a vacuum deposited metallic layer, a pattern layer and a heat sensitive adhesive layer. Again no optical security feature is provided.

This invention provides a pre-imaged high resolution transfer foil comprising a flexible carrier having a surface, a releasable hardcoat disposed on said surface, a vacuum-deposited coating disposed directly on the hardcoat and an image formed in the vacuum-deposited coating and lying solely in the plane thereof and adhesive means encapsulating said vacuum-deposited coating; wherein the vacuum-deposited coating is an optically variable multilayer thin film coating which changes color with a change in viewing angle and in that the image is a graphic image etched in the vacuum-deposited coating so that said hardcoat remains intact.

For example the carrier may be formed of PET and may have a thickness ranging from 10.1 to 50.8 microns (40 gauge to 200 gauge).

The invention also provides an article comprising a flexible substrate having a surface, an adhesive deposited on said surface, a vacuum-deposited coating secured to the adhesive, an image formed in said vacuum-deposited coating, a protective hardcoat overlying the vacuum-deposited coating and; wherein the vacuum-deposited coating is an optically variable multilayer thin film coating which changes color with a change in viewing angle and the image is a graphic image formed in the vacuum deposited coating leaving the hardcoat intact.

According to a further optional feature of the invention the article may also include overprinting carried on the protective hardcoat.

In the preferred embodiment of the invention the substrate may be formed of plastic.

In any of the above arrangements the substrate may be transparent or opaque.

The invention further provides a method for producing a high resolution image of graphic quality on a substrate providing a flexible carrier, depositing a hardcoat on carrier, depositing a vacuum-deposited coating on the release coat, forming an image in the vacuum-deposited coating, placing an adhesive either on the vacuum deposited coating or on the substrate, bringing the substrate and the carrier into engagement with each other so that the image carried by the carrier comes into engagement with the adhesive, applying heat and pressure to the carrier and the vacuum-deposited coating carried thereby to cause the vacuum-deposited coating having the image therein to be bonded to the adhesive, wherein the vacuum-deposited coating is formed as an optically variable multilayer thin film coating which changes color with a change in viewing angle and in that the image is formed by etching a graphic image in the vacuum-deposited coating leaving the release hardcoat intact.

In one particular method according to the invention the step of etching the image in the vacuum-deposited coating may be accomplished by depositing a photoresist on the vacuum-deposited coating, exposing the photoresist to an image, developing the photoresist to provide a pattern of the image in the photoresist, etching the pattern of the photoresist into the vacuum-deposited coating and removing the photoresist after the etching has been completed.

The method may also include the step of applying a protective coat.

The method may further include the step of applying overprinting on the protective coat.

Additional objects and features of the invention will appear from the following description in which the preferred embodiment is set forth in detail in conjunction with the accompanying drawings.

Figure 1 is a plan view of an article in the form of an employee badge which incorporates the present invention.

Figures 2, 3, 4, 5 and 6 are cross-sectional views showing the various steps in the method used for making the foil and an article of the present invention.

In general, the pre-imaged high resolution transfer foil consists of a carrier having a surface, a releasable hardcoat disposed on the surface of the carrier, a vacuum coating disposed on the hardcoat and an image formed in the vacuum coating.

In general the article of the present invention is comprised of a substrate having a surface. An adhesive is disposed on the surface. A vacuum coating is carried by and is secured to the adhesive. An image is formed in the vacuum coating and a protective coat is provided on the vacuum coating. If desired, an overprint can be provided on the protective coat.

In general in the method a carrier film is provided. A releasable hardcoat is deposited on the carrier film, a vacuum coating is then deposited on the releasable hardcoat. A photo-resist is deposited on the vacuum coating and the photo-resist is exposed to an image. The photo-resist is thereafter developed to provide a foil carrying an image. A substrate serving as a carrier film is then provided and an adhesive is provided on the image side of the foil or on the substrate. Heat and pressure is then utilized to transfer the image on the foil to the substrate with the adhesive being disposed between the image and the substrate. After the transfer has been made, the carrier film is removed.

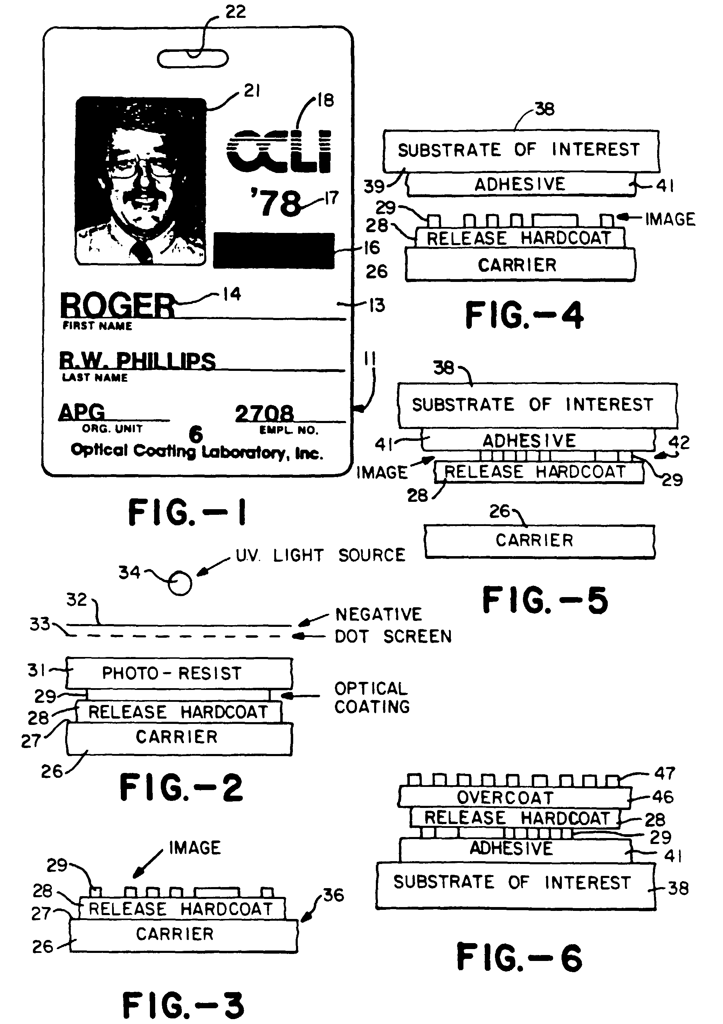

More in particular, the pre-imaged high resolution transfer foil, article and method may now be described in conjunction with Figures 1-6. In Figure 1, there is shown an employee badge or article 11 incorporating the present invention. The employee badge utilizes a substrate 12 formed of a suitable relatively rigid material such as a clear thick polycarbonate. The card as shown is rectangular in form and is provided with a front surface 13 on which there appears conventional printing 14, a stripe 16 indicating the security classification of the employee, a date 17 indicating the date of hire of the employee, a logo 18 of the employer and a pattered optical variable device photograph 21 of the employee made in accordance with the present invention as hereinafter described. The employee badge 11 also is provided with a slot 22 which can be utilized for a strap secured to suitable fastening means such as a clip (not shown) to facilitate wearing of the badge by the employee.

In producing the image or photograph 21 which is shown on the badge 11 the method which is shown in Figures 2-6 is utilized.

In accordance with the present invention as shown in Figure 2, a carrier film formed of a suitable material is provided. The carrier can be of a relatively flexible plastic material as, for example, PET (polyethyleneterephthalate) of a suitable gauge ranging from 10.1 to 50.8 microns (40 gauge to 200 gauge). The carrier 26 is provided with a surface 27 upon which there is deposited a release hardcoat layer 28. The release hardcoat 28 can be of any suitable material such as an organic wax, an acrylic type coating having wax components or a silicone type release material, all well known to those skilled in the art. It is merely necessary that the hardcoat layer have integrity during a vacuum coating process hereinafter described and have the capability in connection with a hot stamping process or a transfer roll-on process so that the carrier can be released from the device it carries.

After the release hardcoat layer 28 has been deposited, a layer 29 is deposited in a vacuum which can be characterized as the optical coating which is to receive the image. Typically this vacuum deposited optical coating can be in the form of a single metal layer or in the form of a multilayer optical coating. By way of example, the optical coating can be in the form of an optically variable device such as is disclosed in US-A-4705356. A layer 31 of photo-resist is then deposited over the layer 29. The photo-resist can be of a conventional type, and can be either a negative or positive photo-resist. The photo-resist 31 is then exposed to the graphic quality image to be incorporated into the coating 29. Tne image is carried by the negative 32. In order to provide improved resolution and to replicate the grey shades in the negative, a dot screen 33 can be utilized if desired. The photo-resist is exposed through the image 32 and the dot screen 33 utilizing ultraviolet light provided by an ultraviolet light source 34. If desired, the dot screen 33 can be utilized for placing hidden messages or other covert features into the design in the coating 29.

After the photo-resist has been exposed, it can be developed by an appropriate developer depending on whether a positive or negative photo-resist is utilized. After the photo-resist is developed to remove certain portions of the photo-resist so that the image is provided in the photo-resist to expose the optical coating 29 therebelow. The assembly which is shown in Figure 2 is subjected to an etching step by a suitable etchant which can etch the optical coating 29. Typically this can be an acid or alkaline etch or FeCL₃ (ferric chloride) in the case of copper etching.

The portion of the optical coating exposed through the photo-resist is then etched away so that the image is carried into the optical coating. After the etching operation has been completed, the remaining photo-resist can be removed in a stripping operation by a suitable photo-resist stripper to provide the assembly shown in Figure 3 which can be identified as a foil that carries the desired image in the vacuum deposited optical coating lying solely in a plane which is secured to the carrier 26 by the release coat 28. The image as shown in Figure 3 has within the image with voids therebetween.

Let it be assumed that it is now desired to deposit the image carried by the foil 36 onto a substrate 38 of interest which is provided with a planar surface 39 as shown in Figure 4 on which it is desired to deposit the image. A coat or layer of adhesive 41 is then placed on the surface 39 of the substrate 38 or alternatively, the adhesive layer 41 can be placed over the optical coating 29 carrying the image. In the drawing the adhesive is shown being deposited on the surface 39. After the adhesive layer 41 has been applied, the carrier carrying the image can then be brought into contact with the substrate 38. Typically this is accomplished by utilizing heat and pressure utilizing a flat die stamp in a reciprocating hot stamping machine or in a roll on transfer process using heated pressure rollers. The time and pressures required for such a step are well known to those skilled in the art. As soon as this transfer has been effected, the carrier 26 can be stripped away so that there remains the article 42 which is comprised of the substrate 38, the adhesive 41 which secures the optical coating 29 to the substrate covered by the release coat 28.

The release hardcoat 28 can be left in place to protect the image. If desired, an additional protective overcoat 46 can be provided. Also printing 47 of a conventional type can then be printed on the overcoat 46.

It has been found that in accordance with the present invention by pre-imaging the hot stamp foil 36 the thickness of the carrier can be increased as well as the thickness of the adhesive and the hardcoat without adversely affecting the quality of the hot stamp image. In fact, the transferred image is of a much higher quality than can be obtained with conventional hot stamping processes. In addition, there are no fringes formed in the image and the image is of graphic quality. Thus it can be seen that the present invention can be readily adapted for use on numerous commercial hot stamp products which are presently on the market such as greeting cards, paperback book covers, decals and consumer items, packaging and the like, none of which at the present time have graphic quality images or pictures thereon.

By utilizing the present invention it has been found that in addition to obtaining a graphic quality image that the image is also encapsulated along the edges by the bonding of the adhesive to the hardcoat outside of the image area which makes the transferred image more environmentally resistant.

When an optical variable coating is utilized for the coating 29, it is possible to use the hot stamp image as a security device. The transferred image not only shifts from one color to another in reflected light as the viewing angle is changed but it also has a shift from a positive to a negative image in going from reflected to transmitted light. In addition, by providing the optically variable thin film coating with a magnetic layer as described in EP-A-0341002 a still further security feature can be incorporated into a single image device which greatly enhances the anticounterfeiting capabilities of the device. The device also can incorporate printing. If the printing is of a small size so that it only could be seen under a microscope, another level of security could be provided to provide a total of five security features, three overt and two covert, the photograph, color shift with viewing angle, positive to negative image reversal, magnetic properly, and microscopic printing encoded into photograph.

The present invention relates itself to many types of products as hereinbefore described. For example, the invention lends itself to plastic identification cards of the type shown in Figure 1 and in which an OVD photograph of the person can be incorporated into the card. An optical variable device incorporating the present invention having the high resolution graphics could be used as a seal of authenticity on documents, or for example, on currency. By way of example, the optical variable device could be in the form of a photograph of the president, founder or ruler of the country for that currency. Other security documents such as passports could utilize such optically variable device photographs.

Although the present invention has been described in conjunction with hot stamp foils, it should be appreciated that the method taught herein can be used to apply images directly to optical coatings which are coated directly onto the plastic film. In those situations where the optical coating is deposited directly onto a clear carrier film only the photo-resist coating steps (coating, exposure to UV light and developing) are necessary. If a colored carrier film is used, additional interesting effects can be generated. For example, the color of the carrier film can be adjusted to match one of the colors of the optical variable device so that at a certain angle as, for example, normal viewing, the optically variable device would not be obviously visible as it would blend into the background. At a different viewing angle, however, it would stand out against the background.

In connection with the above it should be appreciated that the substrate of interest 38 can be transparent or opaque. It can be flexible or rigid. Thus six security features can be built into a single device. The color shifter in reflected light, the shift from a positive in reflected light to a negative image in transmitted light, the photograph itself, magnetic qualities with a magnetic layer, microprint images within the OVD and overprinting for the device.

It is apparent from the foregoing that there has been provided a pre-imaged high resolution transfer of foil, article and method which lends itself to many applications, particularly those where anticounterfeiting is important.

## Claims

1. A pre-imaged high resolution transfer foil comprising a flexible carrier (26) having a surface (27), a releasable hardcoat (28) disposed on said surface, a vacuum-deposited coating (29) disposed directly on the hardcoat and an image (21) formed in the vacuum-deposited coating and lying solely in the plane thereof and adhesive means (41) encapsulating said vacuum-deposited coating; characterised in that the vacuum-deposited coating is an optically variable multilayer thin film coating which changes color with a change in viewing angle and in that the image is a graphic image etched in the vacuum-deposited coating so that said hardcoat remains intact.

2. A foil as claimed in Claim 1, characterised in that said carrier (26) is formed of PET.

3. A foil as claimed in Claim 2, characterised in that said carrier (26) has a thickness ranging from 10.1 to 50.8 microns (40 gauge to 200 gauge).

4. An article comprising a flexible substrate (38) having a surface, an adhesive (41) deposited on said surface, a vacuum-deposited coating (29) secured to the adhesive, an image formed in said vacuum-deposited coating, and a protective hardcoat (28) overlying the vacuum-deposited coating; characterized in that the vacuum-deposited coating (29) is an optically variable multilayer thin film coating which changes color with a change in viewing angle, and in that the image is a graphic image formed in the vacuum deposited coating (29) leaving the hardcoat intact.

5. An article as claimed in Claim 4 together with overprinting (47) carried on the protective hardcoat.

6. An article as in Claim 4 or Claim 5, characterised in that said substrate (38) is formed of plastic.

7. An article as in any of Claims 4 to 6, characterised in that said substrate (38) is transparent.

8. An article as in any of Claims 4 to 6 characterised in that said substrate (38) is opaque.

9. In a method for producing a high resolution image of graphic quality on a substrate providing a flexible carrier, depositing a release hardcoat on carrier, depositing a vacuum-deposited coating on the release hardcoat, forming an image in the vacuum-deposited coating, placing an adhesive either on the vacuum deposited coating or on the substrate, bringing the substrate and the carrier into engagement with each other so that the image carried by the carrier comes into engagement with the adhesive, applying heat and pressure to the carrier and the vacuum-deposited coating carried thereby to cause the vacuum-deposited coating having the image therein to be bonded to the adhesive, characterized in that the vacuum-deposited coating is formed as an optically variable multilayer thin film coating which changes color with a change in viewing angle and in that the image is formed by etching a graphic image in the vacuum-deposited coating leaving the release hardcoat intact.

10. A method as in Claim 9 wherein the step of etching the image in the vacuum-deposited coating is accomplished by depositing a photoresist on the vacuum-deposited coating, exposing the photoresist to an image, developing the photoresist to provide a pattern of the image in the photoresist, etching the pattern of the photoresist into the vacuum-deposited coating and removing the photoresist after the etching has been completed.

11. A method as in Claim 9 or Claim 10 together with the step of applying a protective coat.

12. A method as in Claim 11 together with the step of applying overprinting on the protective coat.

## Patentansprüche

1. Mit einem Bild versehene, hoch auflösende Umdruckfolie mit einem flexiblen Träger (26) mit einer Oberfläche (27), einer lösbaren harten Schicht (28) auf der Oberfläche, einer im Vakuum abgeschiedenen, direkt auf der harten Schicht angebrachten Beschichtung (29) und einem Bild (21), das in der im Vakuum abgeschiedenen Beschichtung ausgebildet ist und ausschließlich in deren Ebene liegt, sowie eine die im Vakuum abgeschiedene Beschichtung einschließende Klebeeinrichtung (41); dadurch gekennzeichnet, daß die im Vakuum abgeschiedene Beschichtung eine optisch variable, aus vielen dünnen Schichten bestehende Beschichtung ist, die mit dem Betrachtungswinkel die Farbe verändert, und daß das Bild ein in die im Vakuum abgeschiedene Beschichtung geätztes graphisches Bild ist, so daß die harte Schicht intakt bleibt.

2. Folie nach Anspruch 1, dadurch gekennzeichnet, daß der Träger (26) aus PET gefertigt ist.

3. Folie nach Anspruch 2, dadurch gekennzeichnet, daß der Träger (26) eine Dicke hat, die zwischen 10,1 und 50,8 µm liegt (Dickezahl 40 bis Dickezahl 200).

4. Artikel mit einem flexiblen Substrat (38) mit einer Oberfläche, einem auf der Oberfläche aufgetragenen Kleber (41), einer im Vakuum abgeschiedenen, am Kleber haftenden Beschichtung (29), einem in der im Vakuum abgeschiedenen Beschichtung geformten Bild und einer über der im Vakuum abgeschiedenen Beschichtung liegenden schützenden harten Schicht (28), dadurch gekennzeichnet, daß die im Vakuum abgeschiedene Beschichtung (29) eine optisch variable, aus vielen dünnen Schichten bestehende Beschichtung ist, die mit dem Betrachtungswinkel die Farbe verändert, und daß das Bild ein in der im Vakuum abgeschiedenen Beschichtung (29) geformtes graphisches Bild ist, wobei die harte Schicht intakt bleibt.

5. Artikel nach Anspruch 4, mit einem auf der schützenden harten Schicht aufgetragenen Überdruck.

6. Artikel nach Anspruch 4 oder 5, dadurch gekennzeichnet, daß das Substrat (38) aus Kunststoff ist.

7. Artikel nach einem der Ansprüche 4 bis 6, dadurch gekennzeichnet, daß das Substrat (38) transparent ist.

8. Artikel nach einem der Ansprüche 4 bis 6, dadurch gekennzeichnet, daß das Substrat (38) undurchsichtig ist.

9. Verfahren zum Herstellen eines hochauflösenden Bildes graphischer Qualität auf einem Substrat mit den folgenden Schritten: Bereitstellen eines flexiblen Trägers, Ablagern einer lösbaren harten Schicht auf dem Träger, im Vakuum Abscheiden einer Beschichtung auf der lösbaren harten Schicht, Formen eines Bildes in der im Vakuum abgeschiedenen Beschichtung, Auftragen eines Klebers entweder auf der im Vakuum abgeschiedenen Beschichtung oder auf dem Substrat, Aufeinanderbringen des Substrates und des Trägers, so daß das vom Träger getragene Bild mit dem Kleber in Kontakt kommt, Einwirken-Lassen von Wärme und Druck auf den Träger und die im Vakuum abgeschiedene Beschichtung, wodurch die im Vakuum abgeschiedene Beschichtung mit dem darin vorhandenen Bild mit dem Kleber verbunden wird, dadurch gekennzeichnet, daß die im Vakuum abgeschiedene Beschichtung als eine optisch variable, aus vielen dünnen Schichten bestehende Beschichtung ausgebildet wird, die mit dem Betrachtungswinkel die Farbe verändert, und daß das Bild dadurch geformt wird, daß ein graphisches Bild in die im Vakuum abgeschiedene Beschichtung geätzt wird, wobei die lösbare harte Schicht intakt bleibt.

10. Verfahren nach Anspruch 9, bei dem der Schritt des Ätzens des Bildes in der im Vakuum abgeschiedenen Beschichtung dadurch bewerkstelligt wird, daß ein Photolack auf die im Vakuum abgeschiedene Beschichtung aufgetragen wird, der Photolack mit einem Bild belichtet wird, der Photolack zum Herstellen des Musters des Bilds entwickelt wird, das Muster des Photolacks in die im Vakuum abgeschiedene Beschichtung eingeätzt wird und der Photolack nach Durchführung des Ätzens entfernt wird.

11. Verfahren nach Anspruch 9 oder Anspruch 10, mit dem Schritt des Anbringens einer Schutzschicht.

12. Verfahren nach Anspruch 11, mit dem Schritt des Anbringens eines Überdrucks auf der Schutzschicht.

## Revendications

1. Feuille de transfert à haute résolution portant une image préformée, comprenant un support souple (26) ayant une surface (27), une couche dure détachable (28) disposée sur ladite surface, un revêtement déposé sous vide (29) disposé directement sur la couche dure et une image (21) formée dans le revêtement déposé sous vide et se trouvant uniquement dans son plan et des moyens d'adhésif (41) encapsulant ledit revêtement déposé sous vide ; caractérisée en ce que le revêtement déposé sous vide est un revêtement de film mince multicouche optiquement variable dont la couleur change avec l'angle de visée et en ce que l'image est une image graphique gravée dans le revêtement déposé sous vide de telle sorte que la couche dure reste intacte.

2. Feuille selon la revendication 1, caractérisée en ce que ledit support (26) est formé de PET.

3. Feuille selon la revendication 2, caractérisée en ce que ledit support (26) a une épaisseur allant de 10,1 à 50,8 micromètres (calibre 40 à 200).

4. Article comprenant un substrat souple (38) ayant une surface, un adhésif (41) déposé sur ladite surface, un revêtement (29) déposé sous vide fixé à l'adhésif, une image formée dans ledit revêtement déposé sous vide et une couche dure protectrice (28) recouvrant le revêtement déposé sous vide ; caractérisé en ce que le revêtement déposé sous vide (29) est un revêtement de film mince multicouche optiquement variable dont la couleur change avec l'angle de visée, et en ce que l'image est une image graphique formée dans le revêtement déposé sous vide (29), laissant la couche dure intacte.

5. Article selon la revendication 4, avec une surimpression (47) portée par la couche dure.

6. Article selon les revendications 4 ou 5, caractérisé en ce que ledit substrat (38) est formé d'une matière plastique.

7. Article selon l'une quelconque des revendications 4 à 6, caractérisé en ce que ledit substrat (38) est transparent.

8. Article selon l'une quelconque des revendications 4 à 6, caractérisé en ce que ledit substrat (38) est opaque.

9. Dans un procédé de production d'une image à haute résolution de qualité graphique sur un substrat en réalisant un support souple, en déposant une couche dure antiadhésive sur le support, en déposant un revêtement déposé sous vide sur la couche dure antiadhésive, en formant une image dans le revêtement déposé sous vide, en plaçant un adhésif soit sur le revêtement déposé sous vide, soit sur le substrat, en amenant le substrat et le support en contact l'un avec l'autre de telle sorte que l'image portée par le support vienne au contact de l'adhésif, en appliquant de la chaleur et une pression sur le support et sur le revêtement déposé sous vide porté par celui-ci pour provoquer la liaison du revêtement déposé sous vide portant l'image, à l'adhésif, caractérisé en ce que le revêtement déposé sous vide a la forme d'un revêtement de film mince multicouche optiquement variable dont la couleur change avec l'angle de visée, et en ce que l'image est formée en gravant une image graphique dans le revêtement déposé sous vide, laissant intacte la couche dure antiadhésive.

10. Procédé selon la revendication 9, dans lequel l'étape de gravure de l'image dans le revêtement déposé sous vide, est effectuée en déposant un photorésist sur le revêtement déposé sous vide, en exposant le photorésist à une image, en développant le photorésist pour donner un dessin de l'image dans le photorésist, en gravant le dessin du photorésist dans le revêtement déposé sous vide et en éliminant le photorésist lorsque la gravure est terminée.

11. Procédé selon les revendications 9 ou 10, avec l'étape d'application d'une couche protectrice.

12. Procédé selon la revendication 11, avec l'étape d'application d'une surimpression sur la couche protectrice.
